(19) Europäisches Patentamt
European Patent Office
Office européen des brevets

(11) EP 4 776 035 A1

(12) EUROPEAN PATENT APPLICATION
published in accordance with Art. 153(4) EPC

(43) Date of publication:
15.07.2026 Bulletin 2026/29

(21) Application number: 24861698.9

(22) Date of filing: 19.07.2024

(51) International Patent Classification (IPC):
G02B 5/18 (2006.01)    G03F 7/20 (2006.01)

(52) Cooperative Patent Classification (CPC):
G02B 5/18; G03F 7/20

(86) International application number:
PCT/CN2024/106356

(87) International publication number:
WO 2025/050853 (13.03.2025 Gazette 2025/11)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 06.09.2023 CN 202311149415

(71) Applicant: Jiangsu Leuven Instruments Co., Ltd.
Xuzhou, Jiangsu 221300 (CN)

(72) Inventors:
• XIE, Tingting
Xuzhou, Jiangsu 221300 (CN)

• DONG, Shuo
Xuzhou, Jiangsu 221300 (CN)
• YANG, Yuxin
Xuzhou, Jiangsu 221300 (CN)
• CUI, Hushan
Xuzhou, Jiangsu 221300 (CN)
• XU, Kaidong
Xuzhou, Jiangsu 221300 (CN)

(74) Representative: Eisenführ Speiser
Patentanwälte Rechtsanwälte PartGmbB
Postfach 10 60 78
28060 Bremen (DE)

(54) MANUFACTURING METHOD FOR BLAZED GRATING

(57) The present application provides a manufacturing method for a blazed grating. The method comprises: providing a substrate, wherein the substrate is covered with periodically arranged masks; and by using an incident angle and a rotation angle, and by using the masks for masking, etching the substrate by means of an ion beam to form a blazed grating. The incident angle is an angle between a first projection of the ion beam on a plane where a normal of the substrate is located and the normal of the substrate, the rotation angle is an angle between a second projection of the ion beam on a plane where the surface of the substrate is located and a tangent of the surface of the substrate, and an anti-blaze angle of the blazed grating is determined on the basis of the incident angle and the rotation angle. In this way, by using the incident angle and the rotation angle, the masking effect of the masks can be reduced, achieving the objective of controlling the anti-blaze angle, and realizing controllability of the anti-blaze angle; thus, by controlling the incident angle and the rotation angle, the anti-blaze angle is increased, and the diffraction efficiency of the blazed grating is finally improved.

```
                                                    S101
┌─────────────────────────────────────────────────────┐
│              Providing a substrate                    │
└─────────────────────────────────────────────────────┘
                           │                    S102
                           ▼
┌─────────────────────────────────────────────────────┐
│ Etching, with the mask serving as a shield, the       │
│ substrate by an ion beam at an incident angle and a   │
│ rotation angle to form the blazed grating             │
└─────────────────────────────────────────────────────┘
```

FIG. 1

EP 4 776 035 A1

## Description

This application claims priority to Chinese Patent Application No. 202311149415.0, titled "MANUFACTURING METHOD FOR BLAZED GRATING", filed on September 6, 2023 with the China National Intellectual Property Administration, which is incorporated herein by reference in its entirety.

## FIELD

The present disclosure relates to the field of semiconductors, and in particular to a method for manufacturing a blazed grating.

## BACKGROUND

With the rapid development of semiconductor technology, the application of the blazed grating is becoming increasingly widespread. For example, the blazed grating can be applied in augmented reality or virtual reality scenarios, such as in optical transmissive near-eye display technology used in these augmented reality or virtual reality scenarios.

Theoretically, the +1st order diffraction efficiency of the blazed grating is 100%. However, in practice, the +1st order diffraction efficiency of the blazed grating is only 65% to 80%. This is because the anti-blaze angle is not a right angle, which results in the light being partially absorbed or reflected.

Therefore, a method that can improve the diffraction efficiency of the blazed grating is needed.

## SUMMARY

In view of the above, an object of the present disclosure is to provide a method for manufacturing a blazed grating. With this method, the anti-blaze angle can be increased and the diffraction efficiency of the blazed grating can be improved.

A method for manufacturing the blazed grating is provided according to the present disclosure. The method comprises:

provided a substrate, where the substrate is covered with a mask arranged periodically;

etching, with the mask serving as a shield, the substrate by an ion beam at an incident angle and a rotation angle to form the blazed grating, where the incident angle is an angle between a first projection of the ion beam on a plane where a normal to the substrate is located and the normal to the substrate, the rotation angle is an angle between a second projection of the ion beam on a plane where a surface of the substrate is located and a tangent to the surface of the substrate, and an anti-blaze angle of the blazed grating is determined based on the incident angle and the rotation angle.

Optionally, the periodically arranged mask has a mask period, a mask line width, and a mask height, and the blazed grating has a blaze angle, the anti-blaze angle, and a grating height;

the anti-blaze angle of the blazed grating is determined based on the incident angle and the rotation angle according to equations comprising:

$$\cos|\alpha| \times \tan|\theta| = \frac{a-b-c}{h},$$

and

$$c = a \times \frac{\tan\beta}{\tan\beta + \tan\gamma},$$

where $\alpha$ is the rotation angle, $\beta$ is the blaze angle, $\gamma$ is the anti-blaze angle, $\theta$ is the incident angle, a is the mask period, b is the mask line width, and h is the mask height.

Optionally,

$$\theta \geq \arctan\frac{a-b}{h}.$$

Optionally, a ratio of a mask etching rate to a substrate etching rate is k; and

$$\tan\beta = \frac{\tan 90° - \theta}{k}.$$

Optionally,

$$h_1 = a \times \frac{\tan\gamma \times \tan\beta}{\tan\gamma + \tan\beta},$$

where $h_1$ is the grating height.

Optionally, an orientation of an acute angle between the ion beam and the plane where the surface of the substrate is located is the same as an orientation of the blaze angle.

Optionally, the mask period ranges from 200 nm to 10 $\mu$m, the mask line width ranges from 5% to 80% of the mask period, and the mask height is greater than or equal to a product of the grating height and k.

Optionally, the rotation angle has a magnitude other than 0°.

Optionally, the rotation angle ranges from -90° to 90°.

Optionally, a material of the mask is the same as a material of the substrate.

Optionally, the material of the substrate is one or

more of $Al_2O_3$, $Ga_2O_3$, $Ta_2O_3$, Si, $SiO_2$, $Si_3N_4$, quartz and $TiO_2$.

Optionally, in a case that the rotation angle is fixed, the orientation of the blaze angle is dependent on a sign of the incident angle, and a magnitude of the blaze angle, a magnitude of the anti-blaze angle, and the grating height are independent of the sign of the incident angle.

Optionally, in a case that the incident angle is fixed, the orientation of the blaze angle, a magnitude of the blaze angle, a magnitude of the anti-blaze angle, and the grating height are independent of a sign of the rotation angle.

Optionally, a lateral etching rate of the substrate is greater when the rotation angle is 0° than when the rotation angle is nonzero.

Optionally, the method further comprises: introducing a first etching gas into a discharge chamber, and introducing a second etching gas into an etching chamber; where the substrate is located in the etching chamber, and the first etching gas is configured for forming a plasma.

Optionally, the first etching gas comprises one or more of inert gas, fluorine-based gas, chlorine-based gas, bromine-based gas, nitrogen, and oxygen, and the second etching gas comprises one or more of fluorine-based gas, chlorine-based gas, bromine-based gas, and oxygen.

Optionally, a gas flow rate of the first etching gas ranges from 10 sccm to 200 sccm, and a gas flow rate of the second etching gas ranges from 50 sccm to 5000 sccm.

Optionally, a beam energy ranges from 50V to 600V.

Optionally, an acceleration voltage is 20% of the beam energy.

Optionally, a beam current ranges from 50 mA to 1200 mA.

A method for manufacturing the blazed grating is provided according to the present disclosure. The method comprises: providing a substrate, where the substrate is covered with a mask arranged periodically; and etching, with the mask serving as a shield, the substrate by an ion beam at an incident angle and a rotation angle to form the blazed grating. The incident angle is an angle between a first projection of the ion beam on a plane where a normal to the substrate is located and the normal to the substrate. The rotation angle is an angle between a second projection of the ion beam on a plane where a surface of the substrate is located and a tangent to the surface of the substrate. An anti-blaze angle of the blazed grating is determined based on the incident angle and the rotation angle. In this way, the shadowing effect of the mask can be reduced by utilizing the incident angle and the rotation angle, thereby achieving the purpose of controlling the magnitude of the anti-blaze angle and realizing the controllability of the anti-blaze angle. Therefore, the anti-blaze angle can be increased by controlling the incident angle and the rotation angle, and the diffraction efficiency of the blazed grating is ultimately improved.

## BRIEF DESCRIPTION OF THE DRAWINGS

Hereinafter, drawings used for describing embodiments are briefly described, so as to illustrate technical solutions in the embodiments of the present disclosure more clearly. Apparently, the drawings described below represent only some of the embodiments of the present disclosure, and other drawings may be obtained by those skilled in the art based on the provided drawings without creative efforts.

FIG. 1 is a schematic flowchart of a method for manufacturing a blazed grating according to an embodiment of the present disclosure.

FIG. 2 is a schematic structural view showing a manufacturing process of a blazed grating according to an embodiment of the present disclosure.

FIG. 3 is a schematic view showing an incident angle according to an embodiment of the present disclosure.

FIG. 4 is a schematic view showing a rotation angle according to an embodiment of the present disclosure.

FIG. 5 is a schematic cross-sectional structural view of a substrate and a mask according to an embodiment of the present disclosure.

FIG. 6 is a schematic cross-sectional structural view of a blazed grating according to an embodiment of the present disclosure.

FIG. 7 is a schematic cross-sectional structural view of a blazed grating according to another embodiment of the present disclosure.

FIG. 8 is a schematic cross-sectional structural view of a blazed grating according to further another embodiment of the present disclosure.

FIG. 9 is a schematic cross-sectional structural view of a blazed grating according to further another embodiment of the present disclosure.

FIG. 10 is a schematic cross-sectional structural view of a blazed grating according to further another embodiment of the present disclosure.

## DETAILED DESCRIPTION OF EMBODIMENTS

Hereinafter, specific embodiments of the present disclosure are described in detail in conjunction with the accompanying drawings, so as to provide a clearer understanding of the above-mentioned objectives, features, and advantages of the present disclosure.

The following description provides numerous specific details to facilitate a thorough understanding of the present disclosure. Alternatively, the present disclosure may be implemented in other forms different from those described herein. Those skilled in the art may make similar extensions without departing from the concept of the present disclosure. Therefore, the present disclosure is not limited to the specific embodiments disclosed below.

The present disclosure is described in detail in conjunction with schematic drawings. When describing the embodiments of the present disclosure, for ease of explanation, cross-sectional views showing device structures may be partially enlarged without being drawn to scale. The schematic drawings are merely illustrative and should not be construed as limitations to the scope of protection of the present disclosure. Furthermore, in actual production, the structures should have three-dimensional dimensions including length, width, and depth.

With the rapid advancement of semiconductor technology, optical transmissive near-eye display technology applied in the augmented reality or virtual reality scenarios has also been greatly developed. The optical transmissive near-eye display technology includes grating-based optical waveguide technology. The grating-based optical waveguide technology achieves transmission of an imaging light beam by utilizing the light dispersion caused by multi-slit diffraction of a grating and the total internal reflection of a waveguide medium. When the light is incident on the grating surface at a certain angle, the grating modulates the amplitude or phase of the incident light wave in a spatial periodical manner, causing the light to be diffracted from the grating surface into several different directions. The grating-based optical waveguide technology is considered the preferred optical solution for consumer-grade augmented reality or virtual reality glasses due to its advantages including a large field of view, excellent display quality, compact size, light weight, and low mass production costs. However, the development of the grating-based optical waveguide technology is further subject to limitations, such as low optical efficiency and significant light loss.

Blazed gratings may be applied in the augmented reality or virtual reality scenarios. The blazed grating is a phase grating that separates the central maximum of diffraction from a surface of each single groove from the zeroth-order maximum of interference among surfaces of multiple grooves, thereby concentrating light energy into the desired order of the diffraction spectrum. Due to its zeroth-order light separation and easy realization of missing orders, the blazed grating achieves high diffraction efficiency. The +1$^{st}$ order diffraction efficiency of the blazed grating is 100% in theory, but only 65% to 80% in practice. This is because the anti-blaze angle is not a right angle, which results in the light being partially absorbed or reflected.

Currently, there are two methods for manufacturing the blazed grating. One is through "pattern transfer" technology, in which a prefabricated blazed grating mold is transferred to a photoresist, and the pattern is completely transferred to the to-be-etched material via chemical etching in a vertical direction. However, this method generally results in arc-shaped corners, preventing the realization of a blazed grating with a vertical anti-blazed surface. The other method involves engraving grooves in the to-be-etched material via "mechanical ruling". However, this ultra-precision machining technique poses extremely high requirements on machining equipment and working environment. Any slight disturbance may compromise ruling precision, making mass production extremely challenging.

Therefore, a method that can improve the diffraction efficiency of the blazed grating is needed.

In view of the above, a method for manufacturing a blazed grating is provided according to the present disclosure. The method includes the following steps. A substrate is provided, where the substrate is covered with a mask that is periodically arranged. With the mask serving as a shield, the substrate is etched by an ion beam at an incident angle and a rotation angle to form the blazed grating. The incident angle is an angle between a first projection of the ion beam on a plane where a normal to the substrate is located and the normal to the substrate. The rotation angle is an angle between a second projection of the ion beam on a plane where a surface of the substrate is located and a tangent to the surface of the substrate. An anti-blaze angle of the blazed grating is determined based on the incident angle and the rotation angle. In this way, the shadowing effect of the mask can be reduced by utilizing the incident angle and the rotation angle, thereby achieving the purpose of controlling the magnitude of the anti-blaze angle and realizing the controllability of the anti-blaze angle. Therefore, the magnitude of the anti-blaze angle can be increased by controlling the incident angle and the rotation angle, and the diffraction efficiency of the blazed grating is ultimately improved.

To facilitate a better understanding of the technical solutions and technical effects of the present disclosure, specific embodiments will be described in detail below in conjunction with the accompanying drawings.

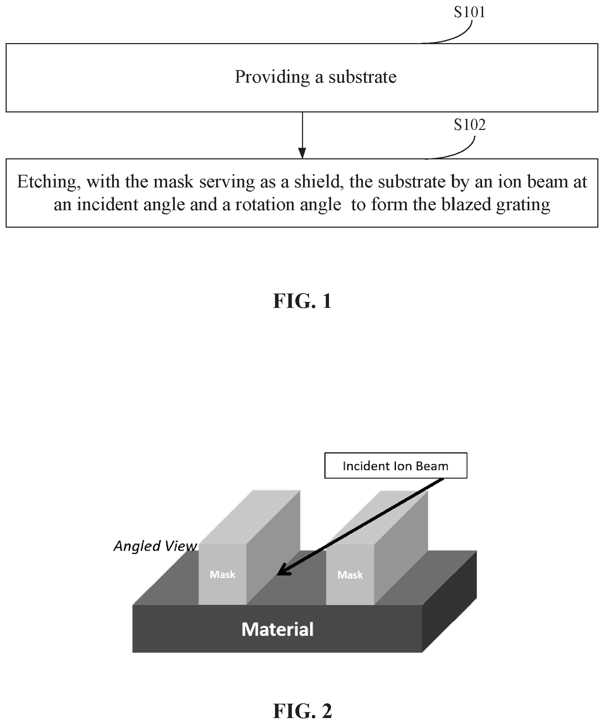

Reference is made to FIG. 1, which is a schematic flowchart of a method for manufacturing a blazed grating according to an embodiment of the present disclosure.

The method for manufacturing the blazed grating according to this embodiment may be applied to semiconductor equipment, such as ion beam etching (IBE) equipment. The IBE equipment includes a discharge chamber and an etching chamber. The discharge chamber is configured to receive a first etching gas, and allow the first etching gas to be ionized into a plasma and then drawn into the etching chamber through a grid. The plasma is then neutralized by electrons generated by a neutralizer, thereby achieving etching. Moreover, a second etching gas is introduced into the etching chamber to assist in etching.

The method for manufacturing the blazed grating according to an embodiment includes the following steps S101 and S102.

In the step S101, a substrate is provided.

In an embodiment of the present disclosure, a material of the substrate is a dielectric material or a high-refractive-index material. For example, the material of the substrate is one or more of $Al_2O_3$, $Ga_2O_3$, $Ta_2O_3$, Si, $SiO_2$, $Si_3N_4$, quartz, and $TiO_2$.

The substrate is covered with a patterned mask. The mask has a periodical arrangement, thereby forming a periodic blazed grating via the periodically arranged mask.

Reference is made to FIG. 2, which is an angled schematic structural view showing the manufacturing process of the blazed grating. The substrate is denoted by "Material", and the mask is arranged periodically. The substrate is disposed in the etching chamber.

In an embodiment of the present disclosure, a material of the mask may be the same as the material of the substrate. In this case, the mask is a homogeneous mask. For example, the material of the substrate is Si and the material of the mask is Si. The material of the mask may be different from the material of the substrate. In this case, the mask is a heterogeneous mask. For example, the material of the substrate is Si and the material of the mask is photoresist.

In the step S102, with the mask serving as a shield, the substrate is etched by an ion beam at an incident angle and a rotation angle to form the blazed grating.

In an embodiment of the present disclosure, the substrate may be etched by the ion beam extracted from the discharge chamber. The ion beam is used as a shortened form of an incident ion beam. Specifically, the substrate is etched by the ion beam at the incident angle and the rotation angle with the mask serving as the shield, thereby forming the blazed grating.

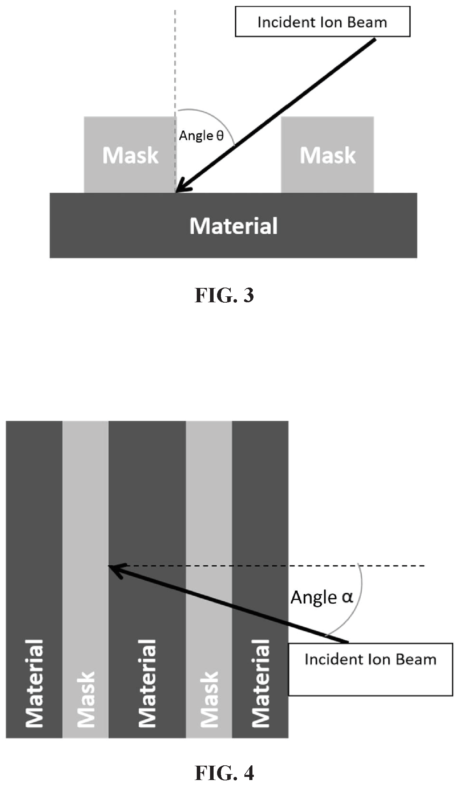

When the ion beam etches the substrate covered with the mask at the oblique incident angle, the substrate is etched to varying degrees at different positions due to obstruction by the mask. The portion of the substrate not shielded by the mask is preferentially etched downward, while the remaining portions of the substrate are gradually etched as the mask is consumed. When the mask is completely consumed, the blazed grating with a predefined groove pattern is formed. The incident angle is an angle between a first projection of the ion beam on a plane where a normal to the substrate is located and the normal to the substrate. Reference is made to FIG. 3, which is a cross-sectional view of the blazed grating during manufacturing. The normal to the substrate is denoted by a dashed line perpendicular to the substrate, and the incident angle is θ.

However, in practice, when the substrate is etched by the ion beam at the oblique incident angle, the strong shadowing effect of the mask results in a small anti-blaze angle of the blazed grating. Therefore, the substrate may be etched by the ion beam not only at the incident angle but also at the rotation angle. The rotation angle is an angle between a second projection of the ion beam on a plane where a surface of the substrate is located and a tangent to the surface of the substrate. Reference is made to FIG. 4, which is a top view of the blazed grating during manufacturing. The tangent to the surface of the substrate is denoted by a dashed line at a right angle to the mask, and the rotation angle is α.

In other words, based on the incident angle, the rotation angle is further incorporated to define the direction of the ion beam. As such, the shadowing effect of the mask can be reduced. This technique alters the lateral etching rate without changing the vertical etching rate of the material to be etched, ultimately achieving control over a magnitude of the anti-blaze angle, i.e., achieving controllable anti-blaze angle.

In an embodiment of the present disclosure, the anti-blaze angle of the blazed grating is determined based on the incident angle and the rotation angle. In other words, the anti-blaze angle can be increased by controlling the incident angle and the rotation angle, thereby ultimately improving the diffraction efficiency of the blazed grating.

In practical applications, the substrate is etched by the ion beam simultaneously at the incident angle and at the rotation angle, i.e., the substrate is etched by the ion beam that is oriented according to both the incident angle and the rotation angle in a single etching process.

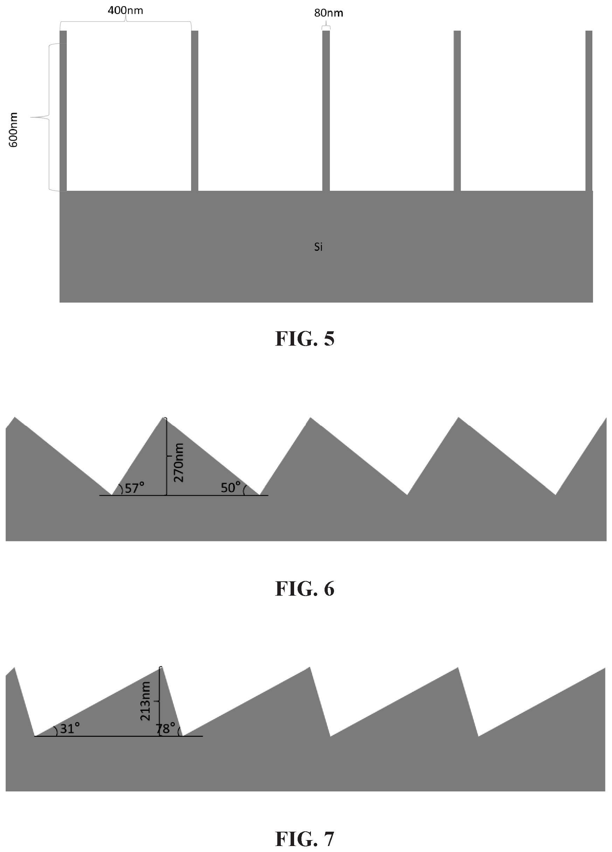

Specifically, structural parameters of the periodically arranged mask include a mask period, a mask line width, and a mask height. Reference is made to FIG. 5, where the material of the substrate is Si, and the material of the mask is Si. The mask height is 600 nm, the mask line width is 80 nm, and the mask period is 400 nm.

Structural parameters of the blazed grating include a blaze angle, the anti-blaze angle, and a grating height.

The anti-blaze angle can be calculated by using the following formulas:

$$\cos|\alpha| \times \tan|\theta| = \frac{a-b-c}{h},$$

and

$$c = a \times \frac{\tan\beta}{\tan\beta+\tan\gamma},$$

where a is the rotation angle, $\beta$ is the blaze angle, $\gamma$ is the anti-blaze angle, $\theta$ is the incident angle, a is the mask period, b is the mask line width, and h is the mask height.

In the above formulas, $0 \leq c \leq a\text{-}b$. When c = 0, $\gamma$ = 90°. When 0 < c < a-b, $\gamma$ < 90°. That is, when c = 0, the anti-blaze angle is 90°. This allows the optimal incident angle and the optimal rotation angle to be inferred from the desired anti-blaze angle. In this way, subsequent etching of the substrate can be performed using the optimal incident angle and the optimal rotation angle, so that the ultimately achieved anti-blaze angle formed by etching is 90°.

In an embodiment of the present disclosure, the rotation angle is nonzero, that is, $\alpha \neq 0$. When the rotation angle is 0, the second projection of the ion beam on the surface of the substrate coincides with the tangent of the surface of the substrate, and the substrate is etched by the ion beam at the incident angle. This may still lead to a small anti-blaze angle.

In an embodiment of the present disclosure, the lateral etching rate of the substrate is greater when the rotation angle is 0 than when the rotation angle is nonzero. In other words, compared with a case where the substrate is etched without using the rotation angle, the lateral etching rate is reduced when using the rotation angle, which is conductive to forming an anti-blaze angle close to 90°.

In practical applications, a lower electrode in the etching chamber is configured to rotate around its own axis to realize control of the rotation angle. The rotation angle ranges from -90° to 90° and is nonzero.

The lower electrode in the etching chamber is configured to revolve around an external axis to achieve control of the incident angle. The incident angle ranges from -90° to 90°. The inherent limitations of the etching chamber confine the revolution to the third and fourth quadrants. That is, when the incident angle is 0, the first projection of the ion beam on the plane where the normal to the substrate is located coincides with the normal to the substrate.

In practical applications, when a direction of a line on the substrate forms an angle of I° with a direction of a line perpendicular to an incident direction of the ion beam, the lower electrode is rotated by -I° around its own axis. This ensures that the direction of the line on the substrate remains parallel to the direction of the line perpendicular to the incident direction of the ion beam, facilitating subsequent calculations of the incident angle and the rotation angle.

In practical applications, $\theta \geq \arctan \dfrac{a-b}{h}$.

When $\theta < \arctan \dfrac{a-b}{h}$, the mask does not exhibit the shadowing effect, and providing the rotation angle is meaningless in this case.

Therefore, the incident angle may be maintained to satisfy the above relationship, so that the anti-blaze angle is close to 90°.

In an embodiment of the present disclosure, when $\alpha$ is the rotation angle, $\beta$ is the blaze angle, $\gamma$ is the anti-blaze angle, $\theta$ is the incident angle, a is the mask period, b is the mask line width, and h is the mask height, the grating height of the blazed grating may be calculated based on the blaze angle, the anti-blaze angle, and the mask period, specifically by the following formula:

$$h_1 = a \times \frac{\tan\gamma \times \tan\beta}{\tan\gamma + \tan\beta},$$

where $h_1$ is the grating height.

In an embodiment of the present disclosure, the materials of the substrate and the mask affect a ratio of a mask etching rate to a substrate etching rate. In a case where the ratio of the mask etching rate to the substrate etching rate is k, the mask height is greater than or equal to a product of the grating height and k, that is, $h \geq kh_1$, where k ranges from 0.1 to 15.

In an embodiment of the present disclosure, the blaze angle may be determined based on the incident angle and the ratio of the mask etching rate to the substrate etching rate, specifically according to the following formula:

$$\tan\beta = \frac{\tan 90° - \theta}{k}.$$

In practical applications, the mask period is within a range of [200 nm, 10 $\mu$m], i.e., the mask period ranges from 200 nm to 10 $\mu$m. The mask line width is within a range of [5%, 80%] of the mask period, i.e., the mask line width ranges from 5% to 80% of the mask period.

In an embodiment of the present disclosure, an orientation of an acute angle between the ion beam and the plane where the surface of the substrate is located is the same as an orientation of the blaze angle. In other words, the incident direction of the ion beam affects the orientation of the blaze angle, so the orientation of the blaze angle can be adjusted by adjusting the direction of the ion beam.

In an embodiment of the present disclosure, when the incident angle is fixed, a sign of the rotation angle does not affect the orientation of the blaze angle, the magnitude of the blaze angle, the magnitude of the anti-blaze angle, or the grating height. In other words, whether the rotation angle is positive or negative does not substantially affect the blazed grating. That is, as long as the second projection of the ion beam on the plane where the substrate surface is located forms a fixed angle with the tangent to the surface of the substrate, the direction of the blaze angle, the magnitude of the blaze angle, the magnitude of the anti-blaze angle, and the grating height will not be affected regardless of which side of the tangent the second projection of the ion beam on the plane, where the substrate surface is located, lies.

In an embodiment of the present disclosure, when the rotation angle is fixed, a sign of the incident angle affects the orientation of the blaze angle, but does not affect the magnitude of the blaze angle, the magnitude of the anti-blaze angle, or the grating height. In other words, whether the incident angle is positive or negative only affects the orientation of the blaze angle, but has no effect on the magnitude of the blaze angle, the magnitude of the anti-blaze angle, or the grating height. That is, as long as the first projection of the ion beam on the plane where the normal to the substrate is located forms a fixed angle with the normal to the substrate, the magnitude of the blaze angle, the magnitude of the anti-blaze angle, or the grating height will not be affected regardless of which side of the normal the first projection of the ion beam on the plane, where the normal to the substrate is located, lies.

In an embodiment of the present disclosure, to etch the substrate, a first etching gas is introduced into the discharge chamber, and a second etching gas is introduced into the etching chamber, thereby etching the substrate using the first etching gas and the second etching gas.

Specifically, the first etching gas includes one or more of an inert gas, a fluorine-based gas, a chlorine-based gas, a bromine-based gas, nitrogen, and oxygen. The second etching gas includes one or more of a fluorine-based gas, a chlorine-based gas, a bromine-based gas, and oxygen. The inert gas may include He, Ne, Ar, Kr, and Xe. The fluorine-based gas may include $CF_4$, $CF_8$, $CHF_3$, $BF_3$, and $SF_6$. The chlorine-based gas may include HCl, $CCl_4$, $BCl_3$, and $Cl_2$. The bromine-based gas may include HBr.

In practical applications, a gas flow rate of the first etching gas ranges from 10 sccm to 200 sccm. This allows a pressure of the discharge chamber to reach 0.1 mtor to 5 mtor, thereby increasing the ion mean free path and facilitating etching.

A gas flow rate of the second etching gas ranges from 50 sccm to 5000 sccm. This allows a pressure of the etching chamber to reach 0.1 mtor to 10 mtor, thereby increasing the ion mean free path and facilitating etching.

In an embodiment of the present disclosure, a beam energy ranges from 50 V to 600 V. Higher beam energy results in greater processing throughput, but an excessively high beam energy may increase sidewall damage. Therefore, the beam energy may be selected based on actual conditions.

In an embodiment of the present disclosure, an acceleration voltage is 20% of the beam energy. This maintains a beam divergence angle of 5° to 15°, improving ion utilization in the plasma and facilitating etching.

In an embodiment of the present disclosure, a beam current ranges from 50 mA to 1200 mA. Higher beam current results in greater processing throughput, but an excessively high beam current may increase sidewall damage. Therefore, the beam current may be selected based on actual conditions.

In practical applications, a beam current generated by the neutralizer is equal to a beam current of the first etching gas. This can achieve complete neutralization, reduce charge accumulation, and maintain the beam divergence angle at 5° to 15°, which improves ion utilization in the plasma and facilitates etching.

Five methods for adjusting the structural parameters of the blazed grating using different incident angles and rotation angles during substrate etching are described as follows.

In a first condition, the mask was a homogeneous mask made of Si, with a mask height of 600 nm, a mask line width of 80 nm, and a mask period of 400 nm. The incident angle was 40°, and the rotation angle was 0. The first etching gas was Ar. The gas flow rate of the Ar was 24 sccm, the beam energy was 400 V, the acceleration voltage was 80 V, and the beam current was 510 mA. After ionizing the Ar to form a plasma, the plasma was extracted through a grid and neutralized. The substrate was etched for 420 seconds. The resulting blazed grating had a grating height of 270 nm, a blaze angle of 57°, and an anti-blaze angle of 50°, as shown in FIG. 6.

In a second condition, the mask was a homogeneous mask made of Si, with a mask height of 600 nm, a mask line width of 80 nm, and a mask period of 400 nm. The incident angle was 35°, and the rotation angle was 49°. The first etching gas was Ar. The gas flow rate of the Ar was 24 sccm, the beam energy was 400 V, the acceleration voltage was 80 V, and the beam current was 510 mA. After ionizing the Ar to form a plasma, the plasma was extracted through a grid and neutralized. The substrate was etched for 315 seconds. The resulting blazed grating had a grating height of 213 nm, a blaze angle of 31°, and an anti-blaze angle of 78°, as shown in FIG. 7. Based on the anti-blaze angle of 78° and backward calculation using the formula, the theoretical rotation angle was 49.16°, which is very close to the rotation angle used in the second condition. Compared to the first condition, with the same mask morphology and incident angle, the anti-blaze angle can be increased by providing the rotation angle, thereby improving the verticality of the anti-blaze angle.

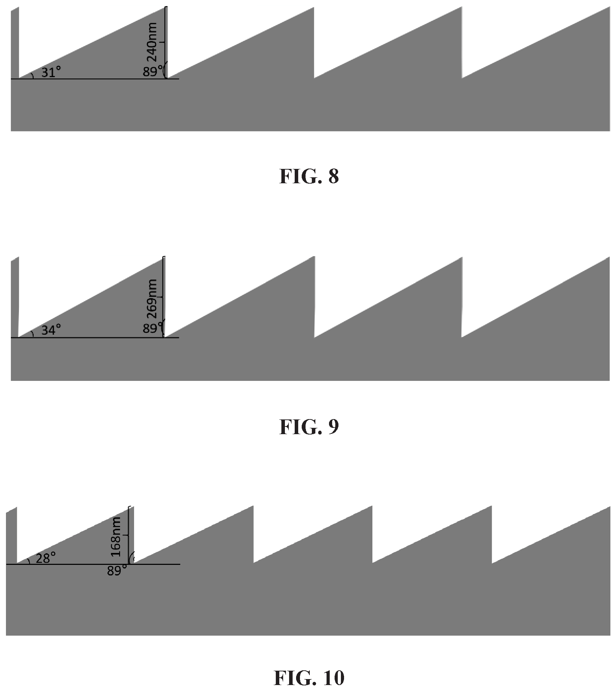

In a third condition, the mask was a homogeneous mask made of Si, with a mask height of 600 nm, a mask line width of 80 nm, and a mask period of 400 nm. The incident angle was 35°, and the rotation angle was 41°. The first etching gas was Ar. The gas flow rate of the Ar was 24 sccm, the beam energy was 400 V, the acceleration voltage was 80 V, and the beam current was 510 mA. After ionizing the Ar to form a plasma, the plasma was extracted through a grid and neutralized. The substrate was etched for 342 seconds. The resulting blazed grating had a grating height of 240 nm, a blaze angle of 31°, and an anti-blaze angle of 89°, as shown in FIG. 8. Based on the anti-blaze angle of 89° and backward calculation using the formula, the theoretical rotation angle was 40.4°, which is very close to the rotation angle used in the third condition. Compared to the second condition, with the same mask morphology and incident angle, the anti-blaze angle can be increased by adjusting the rotation angle, thereby making the anti-blazed surface of the blazed grating nearly vertical.

In a fourth condition, the mask was a homogeneous mask made of Si, with a mask height of 600 nm, a mask line width of 80 nm, and a mask period of 400 nm. The incident angle was 40°, and the rotation angle was 51°. The first etching gas was Ar. The gas flow rate of the Ar was 24 sccm, the beam energy was 400 V, the acceleration voltage was 80 V, and the beam current was 510 mA. After ionizing the Ar to form a plasma, the plasma was extracted through a grid and neutralized, and the substrate was etched for 354 seconds. The resulting blazed grating had a grating height of 269 nm, a blaze angle of 34°, and an anti-blaze angle of 89°, as shown in FIG. 9. Based on the anti-blaze angle of 89° and backward calculation using the formula, the theoretical rotation angle was 50.53°, which is very close to the rotation angle used in the fourth condition. Compared to the third condition, with the same mask morphology, blazed gratings having different blaze angles but both having anti-blaze angles close to 90° can be obtained by adjusting the incident angle and the rotation angle.

In a fifth condition, the mask was a homogeneous mask made of Si, with a mask height of 450 nm, a mask line width of 60 nm, and a mask period of 320 nm. The incident angle was 34°, and the rotation angle was 31°. The first etching gas was Ar. The gas flow rate of the Ar was 24 sccm, the beam energy was 400 V, the acceleration voltage was 80 V, and the beam current was 510 mA. After ionizing the Ar to form a plasma, the plasma was extracted through a grid and neutralized. The substrate was etched for 270 seconds. The resulting blazed grating had a grating height of 168 nm, a blaze angle of 28°, and an anti-blaze angle of 89°, as shown in FIG. 10. Based on the anti-blaze angle of 89° and backward calculation using the formula, the theoretical rotation angle was 31.1°, which is very close to the rotation angle used in the fifth condition. Compared to the third and fourth conditions, with different mask morphology, blazed gratings having different blaze angles but both having anti-blaze angles close to 90° can be obtained by adjusting the incident angle and the rotation angle. That is, the blaze angle and the anti-blaze angle of the blazed grating can be controlled by utilizing the incident angle and the rotation angle.

Therefore, a method for manufacturing the blazed grating is provided according to the present disclosure. The method comprises: providing a substrate, where the substrate is covered with a periodically arranged mask; etching the substrate by an ion beam at an incident angle and a rotation angle with the mask serving as a shield to form the blazed grating. The incident angle is an angle between a first projection of the ion beam on a plane where a normal to the substrate is located and the normal to the substrate. The rotation angle is an angle between a second projection of the ion beam on a plane where a surface of the substrate is located and a tangent to the surface of the substrate. An anti-blaze angle of the blazed grating is determined based on the incident angle and the rotation angle. In this way, the shadowing effect of the mask can be reduced by utilizing the incident angle and the rotation angle, thereby achieving the purpose of controlling the magnitude of the anti-blaze angle and realizing the controllability of the anti-blaze angle. Therefore, the anti-blaze angle can be increased by controlling the incident angle and the rotation angle, and the diffraction efficiency of the blazed grating is ultimately improved.

The foregoing merely represents preferred embodiments of the present disclosure. Although the present disclosure has been disclosed as preferred embodiments, these embodiments are not intended to limit the present disclosure. Anyone skilled in the art can utilize the methods and technical content disclosed above to make multiple possible variations and modifications to the technical solutions of the present disclosure, or to create equivalent embodiments with equivalent variations, without departing from the scope of the present disclosure. Therefore, any simple modifications, equivalent variations, and modifications to the above embodiments based on the technical essence of the present disclosure without departing from the present disclosure remain within the scope of protection of the present disclosure.

**Claims**

1.  A method for manufacturing a blazed grating, comprising:

    providing a substrate, wherein the substrate is covered with a mask that is periodically arranged; and
    etching, with the mask serving as a shield, the substrate by an ion beam at an incident angle and a rotation angle to form the blazed grating, wherein
    the incident angle is an angle between a first projection of the ion beam on a plane where a normal to the substrate is located and the normal to the substrate, the rotation angle is an angle between a second projection of the ion beam on a plane where a surface of the substrate is located and a tangent to the surface of the substrate, and an anti-blaze angle of the blazed grating is determined based on the incident angle and the rotation angle.

2.  The method according to claim 1, wherein

    the mask that is periodically arranged comprises a mask period, a mask line width, and a mask height, and the blazed grating comprises a blaze angle, the anti-blaze angle, and a grating height; the anti-blaze angle of the blazed grating is determined based on the incident angle and the rotation angle by formulas comprising:

$$\cos|\alpha| \times \tan|\theta| = \frac{a-b-c}{h}$$

, and

$$c = a \times \frac{\tan\beta}{\tan\beta + \tan\gamma},$$

wherein $\alpha$ is the rotation angle, $\beta$ is the blaze angle, $\gamma$ is the anti-blaze angle, $\theta$ is the incident angle, a is the mask period, b is the mask line width, and h is the mask height.

3. The method according to claim 2, wherein

$$\theta \geq \arctan\frac{a-b}{h}.$$

4. The method according to claim 2, wherein a ratio of a mask etching rate to a substrate etching rate is k; and

$$\tan\beta = \frac{\tan 90° - \theta}{k}.$$

5. The method according to claim 2, wherein

$$h_1 = a \times \frac{\tan\gamma \times \tan\beta}{\tan\gamma + \tan\beta},$$

wherein $h_1$ is the grating height.

6. The method according to claim 2, wherein an orientation of an acute angle between the ion beam and the plane where the surface of the substrate is located is the same as an orientation of the blaze angle.

7. The method according to claim 4, wherein the mask period ranges from 200 nm to 10 $\mu$m, the mask line width ranges from 5% to 80% of the mask period, and the mask height is greater than or equal to a product of the grating height and k.

8. The method according to claim 1, wherein the rotation angle is nonzero.

9. The method according to claim 8, wherein the rotation angle ranges from -90° to 90°.

10. The method according to claim 1, wherein a material of the mask is the same as a material of the substrate.

11. The method according to claim 10, wherein the material of the substrate is one or more of $Al_2O_3$, $Ga_2O_3$, $Ta_2O_3$, Si, $SiO_2$, $Si_3N_4$, quartz, and $TiO_2$.

12. The method according to claim 2, wherein with the rotation angle fixed, an orientation of the blaze angle is dependent on a sign of the incident angle, and a magnitude of the blaze angle, a magnitude of the anti-blaze angle, and the grating height are independent of the sign of the incident angle.

13. The method according to claim 2, wherein with the incident angle fixed, an orientation of the blaze angle, a magnitude of the blaze angle, a magnitude of the anti-blaze angle, and the grating height are independent of a sign of the rotation angle.

14. The method according to claim 1, wherein a lateral etching rate of the substrate is greater when the rotation angle is 0 than when the rotation angle is nonzero.

15. The method according to claim 1, further comprising:

    introducing a first etching gas into a discharge chamber; and
    and introducing a second etching gas into an etching chamber, wherein
    the substrate is located in the etching chamber, and the first etching gas is configured for forming a plasma.

16. The method according to claim 1, wherein the first etching gas comprises one or more of inert gas, fluorine-based gas, chlorine-based gas, bromine-based gas, nitrogen, and oxygen, and the second etching gas comprises one or more of fluorine-based gas, chlorine-based gas, bromine-based gas, and oxygen.

17. The method according to claim 16, wherein a gas flow rate of the first etching gas ranges from 10 sccm to 200 sccm, and a gas flow rate of the second etching gas ranges from 50 sccm to 5000 sccm.

18. The method according to claim 16, wherein a beam energy ranges from 50 V to 600 V

19. The method according to claim 18, wherein an acceleration voltage is 20% of the beam energy.

20. The method according to claim 1, wherein a beam

**EP 4 776 035 A1**

current ranges from 50 mA to 1200 mA.

S101

Providing a substrate

S102

Etching, with the mask serving as a shield, the substrate by an ion beam at an incident angle and a rotation angle to form the blazed grating

**FIG. 1**

**FIG. 2**

**FIG. 3**

**FIG. 4**

400nm

80nm

600nm

Si

**FIG. 5**

270nm

57° 50°

**FIG. 6**

213nm

31° 78°

**FIG. 7**

**FIG. 8**

**FIG. 9**

**FIG. 10**

## INTERNATIONAL SEARCH REPORT

| International application No. |
| --- |
| **PCT/CN2024/106356** |

| A. | CLASSIFICATION OF SUBJECT MATTER |
| --- | --- |

G02B5/18(2006.01)i; G03F7/20(2006.01)i

According to International Patent Classification (IPC) or to both national classification and IPC

| B. | FIELDS SEARCHED |
| --- | --- |

Minimum documentation searched (classification system followed by classification symbols)

IPC: G02B; G03F7/-

Documentation searched other than minimum documentation to the extent that such documents are included in the fields searched

Electronic data base consulted during the international search (name of data base and, where practicable, search terms used)

CNTXT, ENTXTC, WPABS, CNKI, ENTXT: 闪耀, 光栅, 反闪耀面, 反闪耀角, 离子束, 旋转, 转动, 自转, 入射角, 刻蚀, 蚀刻, 速率, 衍射, 掩膜, 掩模, blazed grating, mask, ion beam, etch+, anti-blaze angle, rotat+

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | CN 115113313 A (UNIVERSITY OF SCIENCE AND TECHNOLOGY OF CHINA) 27 September 2022 (2022-09-27) description, paragraphs [0044]-[0065], and figures 1-11 | 1, 8-11, 14-20 |
| Y | CN 116184546 A (JIANGSU LEUVEN INSTRUMENTS CO., LTD.) 30 May 2023 (2023-05-30) description, paragraphs [0033]-[0063], and figures 1-6 | 1, 8-11, 14-20 |
| Y | CN 102540301 A (SOOCHOW UNIVERSITY) 04 July 2012 (2012-07-04) description, paragraphs [0053]-[0054], and figure 1 | 10-11 |
| A | CN 103091753 A (CHANGCHUN INSTITUTE OF OPTICS, FINE MECHANICS AND PHYSICS, CHINESE ACADEMY OF SCIENCES) 08 May 2013 (2013-05-08) entire document | 1-20 |
| A | CN 114185122 A (BEIJING ZHIGE TECHNOLOGY CO., LTD.) 15 March 2022 (2022-03-15) entire document | 1-20 |

| ✓ Further documents are listed in the continuation of Box C. | ✓ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **22 October 2024** | **25 October 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

EP 4 776 035 A1

**INTERNATIONAL SEARCH REPORT**

International application No.

**PCT/CN2024/106356**

**C.    DOCUMENTS CONSIDERED TO BE RELEVANT**

| Category* | Citation of document, with indication, where appropriate, of the relevant passages | Relevant to claim No. |
|---|---|---|
| A | CN 116009132 A (JIANGSU LEUVEN INSTRUMENTS CO., LTD.) 25 April 2023 (2023-04-25)<br>entire document | 1-20 |
| A | JP H02251904 A (SHIMADZU CORP.) 09 October 1990 (1990-10-09)<br>entire document | 1-20 |
| A | US 7175773 B1 (CARL ZEISS LASER OPTICS GMBH) 13 February 2007 (2007-02-13)<br>entire document | 1-20 |

Form PCT/ISA/210 (second sheet) (July 2022)

**INTERNATIONAL SEARCH REPORT**
Information on patent family members

International application No.

**PCT/CN2024/106356**

| Patent document cited in search report | | | Publication date (day/month/year) | Patent family member(s) | | | Publication date (day/month/year) |
|---|---|---|---|---|---|---|---|
| CN | 115113313 | A | 27 September 2022 | None | | | |
| CN | 116184546 | A | 30 May 2023 | None | | | |
| CN | 102540301 | A | 04 July 2012 | None | | | |
| CN | 103091753 | A | 08 May 2013 | None | | | |
| CN | 114185122 | A | 15 March 2022 | None | | | |
| CN | 116009132 | A | 25 April 2023 | None | | | |
| JP | H02251904 | A | 09 October 1990 | JP | 2841441 | B2 | 24 December 1998 |
| US | 7175773 | B1 | 13 February 2007 | None | | | |

**EP 4 776 035 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202311149415